# EUROPÄISCHE PATENTSCHRIFT

(11) **EP 2 862 208 B1**
(45) Veröffentlichungstag und Bekanntmachung des Hinweises auf die Patenterteilung: **27.04.2016**
(21) Anmeldenummer: 13731682.4
(22) Anmeldetag: 11.06.2013
(51) Int. Cl.: H01L 35/32, H01L 35/34

(54) **GEWICKELTE UND GEFALTETE THERMOELEKTRISCHE SYSTEME UND VERFAHREN ZU DEREN HERSTELLUNG**
WOUND AND FOLDED THERMOELECTRIC SYSTEMS AND METHOD FOR PRODUCING SAME
SYSTÈMES THERMOÉLECTRIQUES ENROULÉS ET PLIÉS ET PROCÉDÉS DE FABRICATION

(30) Priorität: 13.06.2012 DE 102012105086
(43) Veröffentlichungstag der Anmeldung: 22.04.2015
(73) Patentinhaber: Karlsruher Institut für Technologie, 76131 Karlsruhe (DE)
(72) Erfinder: LEMMER, Ulrich, 76228 Karlsruhe (DE); KETTLITZ, Siegfried, 76137 Karlsruhe (DE); GALL, André, 76133 Karlsruhe (DE); GÜLTIG, Marcel, 76187 Karlsruhe (DE)
(86) Internationale Anmeldenummer: PCT/EP2013/001702
(87) Internationale Veröffentlichungsnummer: WO 2013/185903

(56) Entgegenhaltungen:
- WO-A1-2004/105146
- WO-A2-02/23642
- DE-A1- 2 002 197
- JP-A- 2006 100 346
- JP-A- 2006 269 721
- JP-A- 2008 130 594
- US-A- 3 981 751
- US-A1- 2008 173 537
- US-A1- 2011 214 707

## Beschreibung

Die Erfindung betrifft ein thermoelektrisches System zur Nutzung der Thermoelektrizität und ein Verfahren zu dessen Herstellung mit zwei unterschiedlichen, ein Thermopaar bildenden thermoelektrisch aktiven Materialien, welche in Form einer Matrix auf eine flexible und elektrisch isolierende Schicht aufgebracht sind und die Matrix zum thermoelektrischen System gewickelt und gefaltet wird.

Gattungsbildende thermoelektrische Systeme machen sich den Seebeck-, Peltier- und/oder Thomson-Effekt zunutze und können daher als thermoelektrischer Generator, der bei Anordnung in einem Wärmegefälle elektrischen Strom liefert oder als Peltier-Element, das unter Zufuhr elektrischer Energie kühlt oder Wärme erzeugt, ausgebildet sein. Um diese pro Thermopaar gering ausfallenden Effekte wirtschaftlich verwerten zu können, werden bevorzugt mehrere Thermopaare in Serie hintereinander geschaltet.

Beispielsweise ist ein sogenanntes Thermoelement oder thermoelektrisches System mit mehreren aneinander gereihten Thermopaarelementen aus der DE 101 22 679 A1 bekannt. Hierbei werden die Thermopaare auf ein Substrat, beispielsweise eine Folie aufgebracht. Dabei werden einzelne Abschnitte mit voneinander mittels Stegen beabstandeten und sich abwechselnden, thermoelektrisch aktiven Materialien mit unterschiedlichen Seebeck-Koeffizienten plattenweise aneinander angeordnet oder wellenförmig zwischen zwei Schichten wie Kleidungsschichten mit unterschiedlicher Temperatur angeordnet. Durch die großen Zwischenräume zwischen den Streifen der einzelnen thermoelektrisch aktiven Materialien beziehungsweise bei der wellenartigen Struktur der Wellen zueinander sinkt der Wirkungsgrad des Thermoelements. Des Weiteren liegen die thermoelektrisch aktiven Materialien nicht gegeneinander isoliert vor, so dass allein aus Gründen drohender Kurzschlüsse eine weitere Annäherung der Thermopaare nicht möglich ist. Schließlich ist das Thermoelement aufgrund der verwendeten Substratmaterialien aus dünner Folie nicht eigensteif, so dass Anwendungen, bei denen Eigensteifigkeit gefordert ist, einer zusätzlichen Stützstruktur bedürfen.

Ein ähnlich strukturiertes Thermoelektrisches System, wird von Weber et al. vorgestellt (J. Weber, K. Potje-Kamloth, F. Haase, P. Detemple, F. Völklein, T. Doll, "Coin-size coiled-up polymer foil thermoelectric power generator for wearable electronics", Sensors and Actuators, 132 (2006) 325-330). Zur Herstellung dieses Systems wurden Metallfilme auf eine Polyimidfolie gesputtert, welche dann zu einer Spule aufgewickelt wurde. Diese Aufwicklung führt dazu, dass eine Serienschaltung in Endlosform hergestellt werden kann, wobei durch die Wicklung die thermoelektrisch aktiven Materialien gegeneinander isoliert sind. Problem hierbei ist die wellenartige Struktur der thermoelektrisch aktiven Materialien zueinander, denn dadurch entstehen ungenutzte Zwischenräume, die zu parasitärem Wärmefluss führen können. Wünschenswert wäre vielmehr eine optimale Ausnutzung der gesamten Substratfläche durch die Thermopaare.

Willfahrt et al. beschreiben ein Verfahren zum Drucken von Thermoelektrischen Generatoren (TEG) (A. Willfahrt, G. Hübner, E. Steiner, X. Crispin "Screen printed thermoelectric generator in a five layers vertical setup", Proceedings of Large-Area, Organic and Polymer Electronics Convention 28.-30.06.2011 (LOPE-C 11), June 2011, Frankfurt/M., ISBN 978-3-00-034957-7). Hierzu werden thermoelektrisch unterschiedliche Materialen in dünnen Schichten auf ein flächiges Substrat gedruckt, woraus anschließend Streifen ausgeschnitten werden, die übereinander gestapelt und mit leitungsvermittelten Klammern miteinander seriell verbunden werden. Dieses nachträgliche Verbinden ist in einem industriellen Prozess nur mit großem Aufwand möglich, wodurch das Verfahren gewerblich uninteressant wird., Die wellenförmige Struktur der Thermopaare weist darüber hinaus Zwischenräume auf, die zu den bereits erwähnten Problemen führen.

FR 2 620 573 A1 offenbart ein ziehharmonikaartig gefaltetes thermoelektrisches System aus einer Mehrzahl von Thermopaaren, sowie ein Verfahren zu dessen Herstellung. Bei diesem Verfahren werden die unterschiedlichen thermoelektrisch aktiven Materialien zu langen parallelen Streifen auf ein isolierendes Substrat aufgebracht, welches im Folgeschritt mit einer weiteren isolierenden Schicht überzogen und entlang der parallelen Streifen mäanderförmig gefaltet wird. Hierdurch resultiert ein thermoelektrisches System, das zwar die Substratfläche vollständig mit thermoelektrisch aktiven Materialien ausnutzt, jedoch macht die zusätzlich Isolierbeschichtung das Herstellungsverfahren komplizierter und man erhält im resultierenden gefalteten thermoelektrischen System eine zusätzliche Schicht, die zu parasitärem Wärmeabfluss führen kann. Weiterhin hat das in FR 2 620 573 A1 vorgestellte Verfahren Nachteile, wenn für die Beschichtung ein batchweises Druckverfahren angewendet wird, da man auf die Anzahl der Thermopaare beschränkt ist, die in eine Richtung druckbar ist.

Aus CH 413 018 A geht ein gefalteter thermoelektrischer Generator hervor, bei dem die in Zick-Zack-Form gefalteten Thermoelemente durch Aufbringen von alternativen Streifen aus Materialien mit unterschiedlichem thermoelektrischem Potential auf eine elektrisch nichtleitende Filmbasis hergestellt werden.

WO 2005 117 154 A1 offenbart ein thermoelektrisches Halbleitermodul, das durch Druckverfahren oder Abscheiden unter Vakuum hergestellt werden, wobei abwechselnd eine p-leitende und eine n-leitende dünne Schicht der Länge nach auf eine flexible dünne Schicht aufgebracht werden. Die thermoelektrischen Module werden entweder zu einer Spirale oder im Zick-Zack gefaltet.

US 2008/173537 A1 offenbart ein thermoelektrisches System umfassend eine Vielzahl von Thermopaaren aus jeweils zwei Thermoschenkeln unterschiedlicher thermoelektrisch aktiver Materialien (N/P), welche elektrisch in Serie und thermisch parallel geschaltet sind und welche in Form einer Matrix aus n Zeilen mit einer beliebigen Anzahl von Thermoschenkeln in Spalten gleicher Breite auf eine flexible und elektrisch isolierende Schicht aufgebracht sind.

Aufgabe der Erfindung ist daher die vorteilhafte Weiterbildung von thermoelektrischen Systemen und ein Verfahren zur Herstellung dieser vor dem Hintergrund eines verbesserten sicheren Betriebes und einer Großserienfertigung. Die derart hergestellten thermoelektrischen Systeme sollen möglichst kompakt aufgebaut sein, sodass die Anzahl der Isolierschichten minimiert wird. Gleichzeitig soll das System flexibel anpassbar sein auf die unterschiedlichen elektrischen Leitfähigkeiten der beiden das Thermopaar bildenden thermoelektrisch aktiven Materialien. Die Effizienz des thermoelektrischen Systems soll gleichzeitig erhöht werden.

Die Aufgabe wird gelöst durch ein thermoelektrisches System zur Nutzung der Thermoelektrizität mit zwei unterschiedlichen, ein Thermopaar bildenden thermoelektrisch aktiven Materialien, welche elektrisch in Serie und thermisch parallel geschaltet sind. Die thermoelektrisch aktiven Materialien werden in dünnen Schichten auf ein Substrat aufgebracht und derart gewickelt und gefaltet, dass die beiden Schenkel der Thermopaare hochkant in ein thermisches Gefälle positioniert werden können, um das resultierende thermoelektrische System als Peltier Element oder als Thermoelektrischen Generator (TEG) nutzbar zu machen. Die aufrecht stehenden Schichten an thermoelektrisch aktiven Materialien werden im folgenden Thermoschenkel genannt.

Das erfindungsgemäße thermoelektrische System ist in Form einer Matrix aus n Zeilen (mit 2 ≤ n ≤ 1000) mit einer beliebigen Anzahl an Spalten gleicher Breite aus Feldern von thermoelektrisch aktiven Materialien (Thermoschenkeln) aufgebaut, die auf eine flexible und elektrisch isolierende Schicht aufgebracht sind. Durch das abwechselnde Auftragen der beiden unterschiedlichen thermoelektrisch aktiven Materialien entstehen die Thermopaare, durch welche der thermoelektrische Effekt nutzbar ist. Die Kontaktbereiche der beiden unterschiedlichen thermoelektrisch aktiven Materialien aller Thermopaare befinden sich jeweils auf einer Faltlinie in Spaltenrichtung. Die Matrix ist parallel der Zeilen übereinander zu einem Streifen gewickelt und der Streifen ist anschließend entlang der Faltlinien ziehharmonikaartig mit Erhebungen und Vertiefungen gleichen Abstands zueinander zu einem Stapel gefaltet.

In der Theorie kann bei der Auswahl einer geeigneten dünnen flexiblen Schicht die Matrix beliebig häufig gewickelt werden, sodass ein entsprechend dicker Streifen entsteht. Vorzugsweise beträgt aber die Anzahl der Lagen von 2 bis 250, besonders bevorzugt 50 bis 100 Lagen.

Die Zeilenlänge der Matrix kann beliebig gewählt werden. In einer bevorzugten Ausführung der Matrix umfassen alle n Zeilen dieselbe Anzahl an Feldern mit thermoelektrisch aktiven Materialien. In einer weiteren bevorzugten Ausführung der Matrix können die Zeilen um ein oder mehrere Felder versetzt sein. Diese Ausführung macht beispielsweise dann Sinn, wenn die Zeilen nicht in rechtem Winkel zur Beschichtungsrichtung auf die flexible Schicht aufgebracht sind.

Vorzugsweise ist das erfindungsgemäß gewickelte und gefaltete thermoelektrische System zu einem Block verpresst. Optional kann zu diesem Zweck die flexible elektrisch isolierende Schicht auf der Rückseite mit einer Klebeschicht versehen sein. Vorzugsweise handelt es sich hierbei um eine aktivierbare Klebeschicht. Aktivierbar ist in diesem Zusammenhang eine Klebeschicht, die durch die Änderung einer physikalischen Größe aktiviert werden kann, wie z.B. Temperaturerhöhung (bei Verwendung einer Heißsiegelschicht), Druckerhöhung oder Einwirkung von elektromagnetischer Strahlung. Die Klebeschicht kann auch nach der Herstellung der Matrix aber vor der Faltung aufgetragen werden.

Im Rahmen der vorliegenden Erfindung ist ein Thermopaar aus zwei thermoelektrisch aktiven Materialien mit unterschiedlichen Seebeckkoeffizienten gebildet, die unterschiedliche Seebeckspannungen bewirken. Beispielsweise können dies Metallpaarungen und deren Legierungen, Halbleiter als p-Leiter und/oder n-Leiter und/oder elektrisch leitende Polymere oder Mischpolymere, die bevorzugt organischer Natur sein können und gegebenenfalls anorganische Dotierungen aufweisen können, sein. Als organische, thermoelektrisch aktive Materialien eignen sich beispielsweise Polyacetylen, Polyanilin, Polypyrrol, Polythiophen und bevorzugt mit Polystyrolsulfonat dotiertes Poly-3,4-ethylendioxythilophen (PEDOT:PSS) und dergleichen. Organische Polymere, Mischpolymere und dergleichen eignen sich insbesondere zur Herstellung und Verwendung besonders dünner thermoelektrischer Systeme infolge ihrer hohen Elastizität, Verarbeitbarkeit in dünnen Schichten und bezüglich der Einbettschichten ähnlichen Ausdehnungskoeffizienten. Auch Kompositmaterialien enthaltend thermisch isolierende Nano- oder Mikropartikeln in einer organischen Matrix sind gut geeignet als thermoelektrisch aktive Materialien. Beispielsweise hat das Beimischen von SiO₂-Partikeln, welche elektrisch und thermisch isolierend sind, in ein PEDOT:PSS Polymermaterial zur Folge, dass die thermische Leitfähigkeit des Materials stärker herabgesetzt wird als die elektrische Leitfähigkeit. Derartige Materialien sind in US 2009/0314324 A1 offenbart.

Durch die Verwendung flexibler Materialien können während des Wickelns und Faltens der Matrix enge Faltradien vorgesehen werden, die ein Aneinanderlegen und eine gegenseitige Verbindung der Falten unter Bildung eines eigensteifen Blocks mit an den Umkehrpunkten vorgesehen Wellenköpfen ermöglichen, ohne dass die Falten beziehungsweise die Materialien an den Wellenköpfen der Falten übermäßig gedehnt werden oder gar reißen. Es hat sich hierbei als besonders vorteilhaft erwiesen, wenn die Elastizität der flexiblen und elektrisch isolierenden Schicht und der Schichten der die Thermoschenkel bildenden Materialien ähnliche oder gleiche Elastizitäten aufweisen.

Als flexible und elektrisch isolierende Schichten eignen sich dünne, beispielsweise 1 µm bis 100 µm, bevorzugt ca. 10 µm starke Kunststofffolien wie bevorzugt thermoplastische Kunststoffe wie beispielsweise Polyethylen, Polypropylen und dergleichen, Gewebe beispielsweise aus Natur- und/oder Kunstfasern und/oder Lacke beispielsweise auf Kunstharzbasis oder dergleichen, die beispielsweise auf eine glatte Oberfläche aufgesprüht und nach teilweisem oder vollständigem Aushärten mit den thermoelektrisch aktiven Materialien zur Bildung des Streifens behandelt werden.

Erfindungsgemäß wird also ein Stapel aus unterschiedlichen thermoelektrisch aktiven Materialien bereitgestellt, die jeweils durch die flexible und elektrisch isolierende Schicht voneinander abgetrennt sind, damit keine Kurzschlüsse entstehen. Durch die Faltung an den Kontaktstellen der Thermopaare ist gewährleistet, dass der Stapel im Wesentlichen aus parallelen Schichten der beiden thermoelektrisch aktiven Schichten besteht, wobei die Umkehrpunkte der Faltung (Wellenberge und Wellentäler) jeweils zu einer Wärmequelle bzw. zu einer Wärmesenke hin orientierbar sind, wodurch ein thermoelektrischer Generator entsteht. Zur Ausnutzung des erfindungsgemäßen thermoelektrischen Systems als Peltier-Element kann auch ein thermisches Gefälle von Wellenberg zu Wellental erzeugt werden.

Die Materialschichten der thermoelektrisch aktiven Materialien der Thermoschenkel sind mit einer Schichtdicke von beispielsweise 1 µm bis 100 µm, bevorzugt ca. 10 µm ausgebildet und die einzelnen Felder weisen eine Breite zwischen ca. 2 mm bis 40 mm, bevorzugt 5 mm bis 20 mm auf. Es hat sich als vorteilhaft erwiesen, beispielsweise ca. 50 bis 200 Thermopaare pro Zeile nebeneinander zu schalten, so dass bei vorgegebener Länge des Streifens von 0,5 m bis 5 m durch den Wickel- und Faltvorgang Stapel von wenigen Millimetern bis zu mehreren Zentimetern entstehen.

Es versteht sich, dass zur Erzielung von thermoelektrischen Systemen größerer Leistungen eine Vielzahl dieser Stapel in Serie oder parallel geschaltet werden kann und entsprechend große Flächen oder räumliche Anordnungen mit Wärmegradienten mit diesen belegt werden können. Des Weiteren können die Stapel bezüglich ihrer Größe an die thermoelektrischen Gegebenheiten angepasst werden.

Um den Wirkungsgrad zu erhöhen, berühren sich die thermoelektrischen Materialien der Thermoschenkel in bevorzugter Weise über ihre ganze Höhe und überlappen sich zur Herstellung eines gesicherten Kontakts über ihre gesamte Höhe. Alternativ kann zwischen den Kanten der Materialschichten der thermoelektrisch aktiven Materialien eine Zwischenschicht aufgebracht werden, die den Kontakt zwischen den thermoelektrisch aktiven Materialien verbessert. Beispielsweise kann eine derartige Zwischenschicht aus Metall gebildet sein. Die Höhe der Materialschichten ist bevorzugt derart ausgebildet, dass eine Falte jeweils eine Materialschicht des ersten und des zweiten thermoelektrisch aktiven Materials enthält, wobei die Verbindung dieser an den Umkehrpunkten der Falten vorgesehen ist. In diesem Fall ist die Zwischenschicht jeweils an den Umkehrpunkten der Falten und damit an sich gegenüberliegenden Seiten des eigensteifen Blocks angeordnet und kann neben der Kontaktverbesserung gegenüber den thermoelektrisch aktiven Materialien zu einer verbesserten Wärmeankoppelung des Stapels beziehungsweise des aus diesem gebildeten Blocks an die Wärmequelle beziehungsweise Wärmesenke des thermoelektrischen Systems führen.

Bei der Verwendung von unterschiedlichen ein Thermopaar bildende thermoelektrischen Materialien, die eine unterschiedliche Leitfähigkeit aufweisen, wie z.B. ein p-leitendes Polymer und ein metallischer n-Leiter, kann die Fläche des Feldes (Thermoschenkels) des besser leitenden Materials kleiner ausgestaltet werden, sodass innerhalb der Thermopaare die Leitfähigkeit nicht zu stark variiert und Material eingespart werden kann. Das erfindungsgemäße thermoelektrische System erlaubt einen solchen Aufbau in sehr kompakter Form, also ohne dass nutzbare Fläche auf der elektrisch isolierenden Schicht verloren geht. Zu diesem Aufbau werden in jeder Zeile der Matrix abwechselnd Felder der unterschiedlichen Materialien mit der gleichen Breite, aber einer unterschiedlichen Höhe bereitgestellt. Die Breite der Felder sollte identisch sein, damit die Amplitude der Ziehharmonika-Faltung gleichbleibend ist. Die Höhenunterschiede der beiden Thermoschenkel innerhalb einer Zeile, werden durch die versetzten Felder der benachbarten Zeile wieder kompensiert. Wenn beispielsweise auf der Matrix ein n-Leiter 1 mm hoch ist und der p-Leiter 4 mm hoch, so bilden sich innerhalb einer Zeile Stufen aus, welche phasenverschoben mit den p- und n-Leitern der benachbarten Zeile zu einer Doppelzeile ergänzt wird. Es resultiert in der Doppelzeile eine reine Materialhöhe von 5 mm, wobei ein Isolierstreifen zwischen den einzelnen Zeilen vorzusehen ist.

Im Falle der Verwendung unterschiedlich hoher Thermoschenkel kann die Kontaktfläche zwischen den Materialfeldern der Thermopaare angepasst werden. Im einfachsten Falle entspricht die Höhe der Kontaktfläche der Höhe des kleineren Materialfeldes. Vorzugsweise wird die Kontaktfläche derart angepasst, dass zwischen dem kleineren und dem größeren Feld ein dreieckförmiger Kontaktbereich entsteht. Dieser Kontaktbereich entsteht entweder durch Überlappen der beiden thermoelektrischen Materialien oder aber durch die Kontaktierung mit einer kontaktverbessernden Zwischenschicht. Da sich der Kontaktbereich immer an einer Faltstelle befindet, ist die Kontaktstelle einer mechanischen Belastung ausgesetzt. Daher erweist sich die dreieckförmige Kontaktierung als vorteilhaft, da die Faltung über einen größeren Kontaktbereich verläuft als bei der einfachen Kontaktierung.

Die Aufgabe der Erfindung wird im Weiteren durch ein Verfahren zur Herstellung eines thermoelektrischen Systems wie in den Anmeldungsunterlagen beschrieben gelöst. Bei dem Verfahren wird zunächst eine Matrix aus Thermopaaren bildenden Thermoschenkeln auf eine flexible und elektrisch isolierende Schicht aufgebracht. Die Thermoschenkel werden durch Aufbringen von dünnen Schichten thermoelektrisch aktiver Materialien und gegebenenfalls eine diese elektrisch verbindende Zwischenschicht hergestellt, sodass n Zeilen (mit 2 ≤ n ≤ 1000) mit einer beliebigen Anzahl an Thermoschenkeln entstehen, wobei die Kontaktbereiche zwischen den Thermoschenkeln jeweils auf einer Faltlinie in Spaltenrichtung befindlich sind, und wobei die jeweiligen Zeilenenden einen Kontaktbereich mit der benachbarten Zeile ausbilden, damit ein serieller Stromfluss S-förmig über die gesamte Matrix gewährleistet ist. Die so entstandene Matrix wird parallel der Zeilen serieller Thermopaare aufgewickelt, sodass die Zeilen elektrisch gegeneinander isoliert übereinander liegen, wodurch ein mehrlagiger Streifen mit einer beliebigen Anzahl an Lagen entsteht. Vorzugsweise liegt die Anzahl der Lagen zwischen 2 und 200, besonders bevorzugt zwischen 50 und 100. Anschließend wird der mehrlagige Streifen entlang der Faltlinien in Spaltenrichtung ziehharmonikaartig gefaltet zu einem Stapel mit Erhebungen und Vertiefungen gleichen Abstands zueinander.

Bei der Verwendung von Lack als flexible und elektrisch isolierende Schicht kann in einem bevorzugten Verfahrensschritt Lack auf eine glatte Oberfläche, beispielsweise aus Kunststoff, Metall, Keramik, Glas oder dergleichen aufgesprüht, ein oder beide thermoelektrisch aktiven Materialien im getrockneten oder teilweise nassen Zustand des Lacks beispielsweise ebenfalls aufgesprüht, aufgedruckt, aufgedampft oder in anderer Weise aufgebracht werden.

Die Beschichtung der flexiblen und elektrisch isolierenden Schicht kann weiterhin quasi im Endlosverfahren erfolgen, indem das oder die thermoelektrisch aktiven Materialien des Thermopaars in eine Fertigungsrichtung auf eine abspulende Rolle, Platten, die gegenüber einer fest angeordneten Aufbringvorrichtung verlagert und/oder gegenüber einer sich verlagernden Aufbringvorrichtung feststehen, oder dergleichen aufgebracht werden.

Als Verfahren zur Aufbringung der thermoelektrisch aktiven Materialien eignen sich Druckverfahren wie Siebdruckverfahren und bevorzugt Ink-Jet-Verfahren. Entsprechende Drucktinten können beispielsweise Emulsionen, Aüfschlämmungen oder Suspensionen von Metallen, Halbleitern und/oder leitenden Polymeren zur Bildung der thermoelektrisch aktiven Materialien der Thermopaare sowie gegebenenfalls Hilfsstoffe wie Flussmittel, Emulgatoren für einen verbesserten Fluss während des Druckprozesses, die Elastizität verbessernde Mittel wie gelöste Kunststoffanteile mit Weichmachern und dergleichen enthalten. Wahlweise können auch Aufdampfverfahren wie CVD-Verfahren, Sputterverfahren und dergleichen verwendet werden.

Nach der Herstellung der Matrix wird diese zunächst zu einem Streifen gewickelt. Grundsätzlich kann die Matrix beliebig gewickelt sein, wobei nur wesentlich ist, dass die Faltlinien entlang der Spalten übereinander liegen. Die Wicklung der Matrix erfolgt vorzugsweise Zeile.um Zeile, es besteht aber auch die Möglichkeit, mehrere Zeilen auf einmal zu wickeln oder innerhalb einer Zeile mehrfach zu wickeln. Bei der Wicklung ist zu beachten, dass die thermoelektrisch aktiven Schichten gegeneinander elektrisch isoliert sind, sodass kein Kurzschluss entsteht. Dies kann beispielsweise dadurch erfolgen, indem ein Bereich der flexiblen und elektrisch isolierenden Schicht unbedruckt bleibt und dieser beim ersten Wicklungsschritt auf die erste(n) Zeile(n) mit thermoelektrisch aktiven Materialien umgelegt wird. Bei den nachfolgenden Wicklungen liegen immer eine isolierende Schicht und eine bedruckte Schicht übereinander. Vorzugsweise liegen die Falze der Wicklung an den Zwischenräumen der einzelnen Zeilen.

Um den Wickelvorgang im Endlosverfahren zu erleichtern, besteht die Möglichkeit, die Matrix in abgewinkelter Zeilenführung auf die flexible Schicht aufzubringen. Diese abgeschrägte Matrix bietet den Vorteil beim Rolle zu Rolle Herstellverfahren, dass die Wicklung direkt beim Austritt der Matrix aus der Rolle kontinuierlich vorgenommen werden kann. Der entstehende Stapel verlängert sich dementsprechend kontinuierlich durch die schräge Aufwicklung in demselben Winkel zur Fertigungsrichtung, wie es durch die abgewinkelte Zeilenführung vorgegeben ist. Der Stapel kann bei der gewünschten Länge abgeschnitten werden und dem Faltvorgang zugeführt werden.

Der durch die Wicklung erhaltene Streifen wird anschließend ziehharmonikaartig unter Bildung von Falten mit jeweils m Wellenbergen und Wellentälern zu einem Stapel gefaltet. Die entstehenden Falten werden vorzugsweise miteinander verpresst und miteinander haftend unter Bildung eines eigensteifen Blocks verbunden. Bezüglich der haftenden Verbindung der Falten aneinander kann entsprechend der Verbindung der flexiblen und elektrisch isolierenden Schicht miteinander ein Pressvorgang vorgesehen werden, wobei die Haftung durch Laminieren, Kleben oder in anderer Weise adhäsiv oder stoffschlüssig wie Verschweißen erfolgen kann.

Optional kann hierzu in einem weiteren Schritt auf der Rückseite der flexiblen und elektrisch isolierenden Schicht eine Klebeschicht aufgebracht werden. Bei der Verwendung einer aktivierbaren Klebeschicht kann die Beschichtung zu jedem Zeitpunkt des Verfahrens erfolgen. Bei der Verwendung eines direkt haftenden Klebstoffs wird die der Klebstoff vorzugsweise nach der Beschichtung mit den thermoelektrischen Materialien aber vor der Faltung aufgetragen.

Ein mittels des Verfahrens hergestelltes thermoelektrisches System kann als Peltier-Element dienen, das bei Beaufschlagung mit einer vorgegebenen Spannung auf einer Seite der Wellenköpfe der Thermopaarelemente Wärme abgibt und auf der entgegengesetzten Seite Wärme aufnimmt, also als Heizung oder Kühler eingesetzt werden kann. Weiterhin kann bei einer Temperaturdifferenz zwischen den Wellenköpfen an den Polen der hintereinander geschalteten Thermopaarelemente unter Last elektrischer Strom abgenommen werden, der abhängig von der Temperaturdifferenz zwischen den Wellenköpfen ist. Beispielsweise kann bei Verwendung des thermoelektrischen Systems die Körperwärme als elektrische Energiequelle zur Erzeugung von Licht, zum Laden von Elektronikgeräten wie Handys und dergleichen benutzt werden. Weiterhin können derartige thermoelektrische Systeme in der Geothermie zur Erzeugung von Strom verwendet werden, indem beispielsweise großflächige Generatoren unter der Erde eingesetzt werden. Diese sind wartungsfrei und haben keine beweglichen Teile. Des Weiteren können Sensoren, Anzeigegeräte und dergleichen sowie deren Übermittlungseinrichtungen wie Sende- und Empfangsanlagen unabhängig von Netzspannungen betrieben werden, indem die vorgeschlagenen thermoelektrischen Generatoren vorhandene Temperaturdifferenzen bei Abwesenheit anderer Energiequellen zur Erzeugung elektrischer Energie nutzen. Weiterhin können Temperaturdifferenzen erzeugende Energieverluste wie beispielsweise Rest-Abwärme in Kraftwerken, Isolationsverluste in Häusern und dergleichen durch Einbau des vorgeschlagenen thermoelektrischen Generators vermieden oder zumindest gemindert werden.

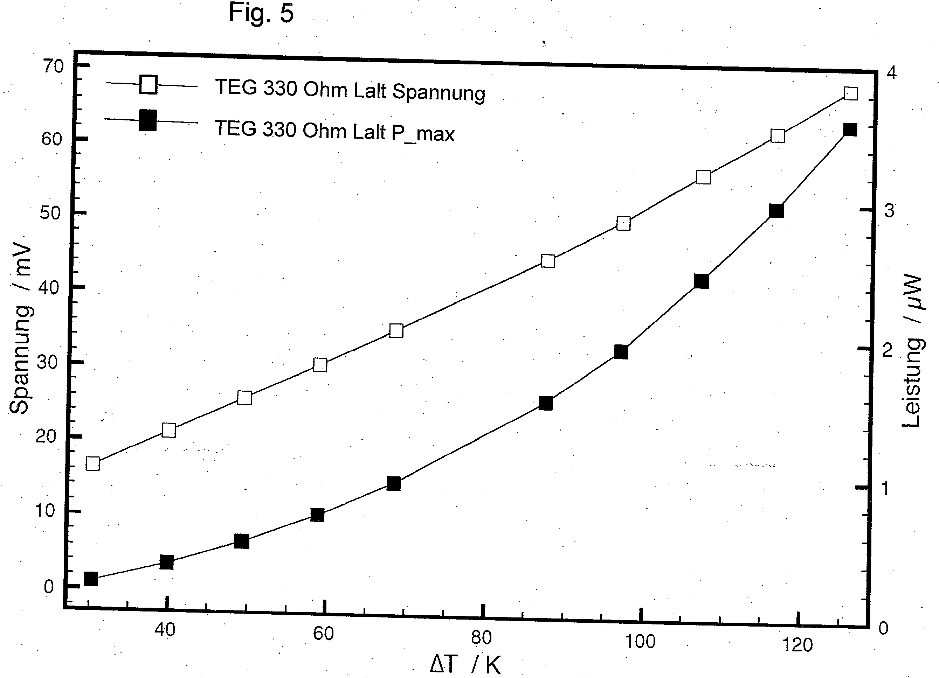

Die Erfindung wird im Folgenden anhand der Figuren 1 bis 5 und den Ausführungsbeispielen näher erläutert.
**Fig. 1** Matrix aus Thermoschenkeln bestehend aus 3 Zeilen mit je 2 Thermopaaren.
**Fig. 2a** Querschnitt einer gewickelten Matrix aus **Fig. 1**
**Fig. 2b** Seitliche Ansicht einer gewickelten Matrix aus **Fig. 1**
**Fig. 3** Schematische Darstellung eines thermoelektrischen Systems in Seitenansicht.
**Fig. 4a** Matrix in einer Ausführungsform mit thermoelektrisch aktiven Materialien unterschiedlicher Leitfähigkeit.
**Fig. 4b** Matrix nach **Fig. 4a** mit dreieckiger Kontaktflächengeometrie.
**Fig. 4c** Matrix nach Fig. 4a und Fig. 4b mit T-förmiger Geometrie
**Fig. 4d** Matrix mit gewinkelter Zeilenführung
**Fig. 5** Spannungs- und Leistungskurve eines thermoelektrischen Generators aus **Beispiel 1** als Funktion von ΔT.

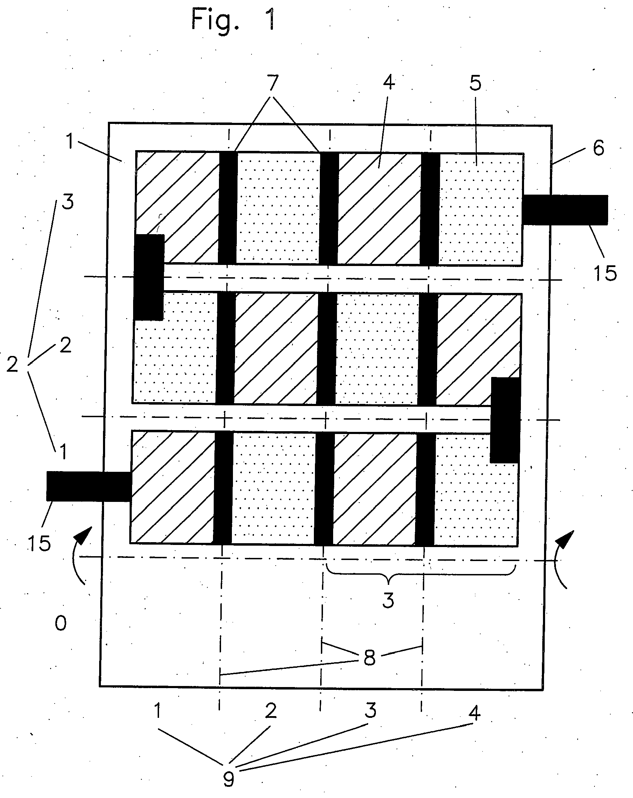

Die **Fig. 1-3** stellen schematisch an einer einfachen Ausführungsform die Herstellung eines erfindungsgemäßen thermoelektrischen Systems **11** dar. Zunächst wird eine Matrix **1** nach **Fig. 1** bereitgestellt bestehend aus drei Zeilen **2** mit je zwei Thermopaaren **3** aus zwei unterschiedlichen thermoelektrisch aktiven Materialien (**4,5**), hier vereinfachend als n-Leiter **4** und p-Leiter **5** bezeichnet, welche auf eine flexible und elektrisch isolierende Schicht **6** aufgebracht sind. Die n- und p-Leiter (**4,5**) sind jeweils in Serie geschaltet und über einen Kontaktbereich **7**, der beispielsweise
in Form einer Überlappung der unterschiedlichen thermoelektrisch aktiven Materialien (**4,5**)oder einer kontaktverbessernde Zwischenschicht elektrisch miteinander verbunden. In **Fig. 1** sind die einzelnen Zeilen **2** der Matrix und die Faltlinien **8** entlang der Spalten **9** konkret dargestellt. Hier ist zu erkennen, dass die Faltlinien **8** genau entlang der Kontaktbereiche **7** zwischen den n- und p-Leitern (**4,5**) der einzelnen Zeilen **2** verlaufen. Die Kontaktflächen **15** sind elektrisch leitend mit dem ersten bzw. letzten n-Leiter **4** bzw. p-Leiter **5** verbunden und dienen der äußeren Kontaktierung des thermoelektrischen Systems **11**.

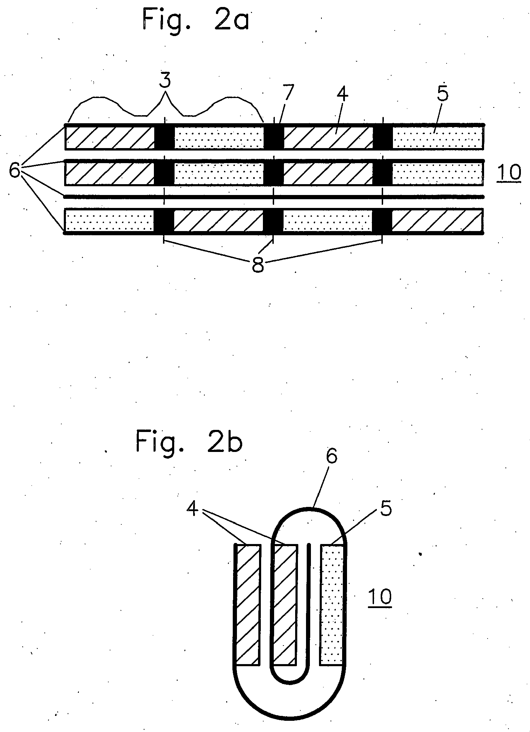

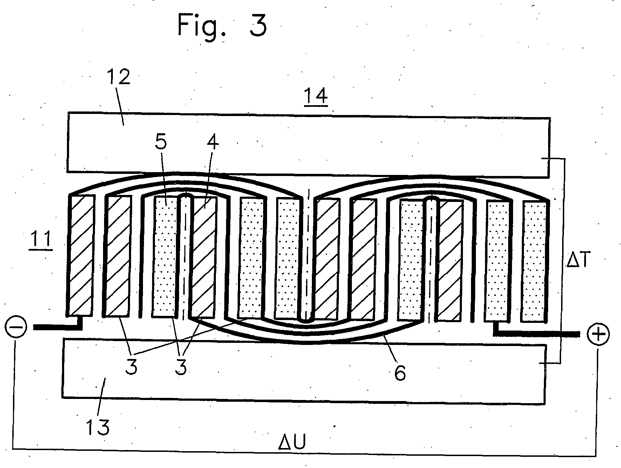

In einem ersten Schritt wird die Matrix **1** parallel der Zeilen **2** aufgewickelt, wobei zu beachten ist, dass die thermoelektrisch aktiven Materialien (**4,5**) voneinander isoliert sind, damit kein Kurzschluss im thermoelektrischen System **11** entsteht. Im vorliegenden Fall wird die nullte Zeile der unbeschichteten elektrisch isolierenden Schicht **6** eingeschlagen, bevor die Matrix **1** dann Zeile um Zeile zu einem Streifen **10** aufgewickelt wird. Durch die einseitige Beschichtung ist gewährleistet, dass jede Zeile **2** elektrisch isoliert ist. Grundsätzlich ist aber eine beliebige Wicklung möglich sofern sie parallel zu den Zeilen **2** verläuft. Der aus der Wicklung resultierende Streifen **10** ist in einer Querschnittszeichnung in **Fig. 2a** schematisch abgebildet. **Fig**. **2b** zeigt die Seitenansicht dieses Streifens **10**, woraus hervorgeht wie die Schichten der thermoelektrisch aktiven Materialien (**4,5**, Thermoschenkel) durch die elektrisch isolierende Schicht **6** voneinander getrennt sind. Der Streifen **10** wird im Folgeschritt entlang der Kontaktbereiche **7,** die übereinander liegen, ziehharmonikaartig zu einem Stapel gefaltet. Aus dieser.Faltung resultiert ein thermoelektrisches System **11** in einer mäanderförmigen Konfiguration der Thermoschenkel (**Fig. 3**), wobei das Herstellverfahren gewährleistet, dass der elektrische Strom im n-Leiter **4** immer in der gleichen Richtung des Wärmegradienten fließt und der Strom im p-Leiter **5** entsprechend immer in umgekehrter Richtung fließt.

Die **Fig. 3** zeigt schematisch einen Querschnitt des thermoelektrischen Systems 11 in Form des zwischen den Wärmeblöcken **12, 13** mit der Temperaturdifferenz ΔT wirksamen thermoelektrischen Generators **14**. Zur Bereitstellung des thermoelektrischen Effekts des thermoelektrischen Generators 14 ist zwischen den Wärmeblöcken **12,13** ein Stapel, der gemäß der **Fig. 1-3** hergestellt wurde, mit einem Thermopaar **3** aus zwei thermoelektrisch aktiven Materialien **4,5** mit unterschiedlichem Seebeck-Koeffizienten angeordnet. Die sechs (n = 3) Thermopaare **3** bzw. zwölf Thermoschenkel sind hintereinander geschaltet, wobei aufgrund des thermoelektrischen Effekts bei Serienschaltung zwischen den Polen +, - abhängig von der Temperaturdifferenz ΔT zwischen den Wärmeblöcken **12,13** eine Spannungsdifferenz ΔU aufgebaut wird, aus der unter Last elektrischer Strom gewonnen werden kann.

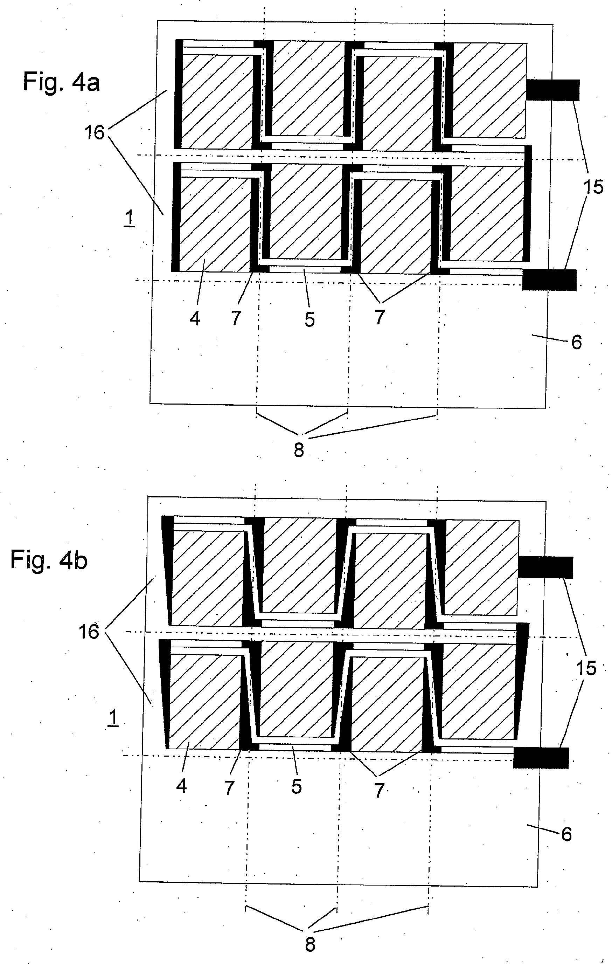

In **Fig. 4a** und **Fig. 4b** sind weitere Ausführungsformen der Matrix **1** dargestellt, die vorteilhaft sind, wenn die Materialien der Thermoschenkel unterschiedliche elektrische Leitfähigkeiten aufweisen. Wenn beispielsweise der p-Leiter **5** besser leitet als der zum Thermopaar gehörende n-Leiter **4** kann die Materialfläche der beiden Thermoschenkel **4,5** derart angepasst werden, dass der p-Leiter **5** eine geringere Höhe aufweist als der n-Leiter **4.** Wie in **Fig. 4a** und **Fig. 4b** dargestellt, können die Felder der beiden Thermoschenkel, die unterschiedlich hoch sind, mit dem jeweils benachbarten Feld der nächsten Zeile **2** passgenau zu einer Doppelzeile **16** ergänzt werden, was zu einer kompakten Bauweise führt.

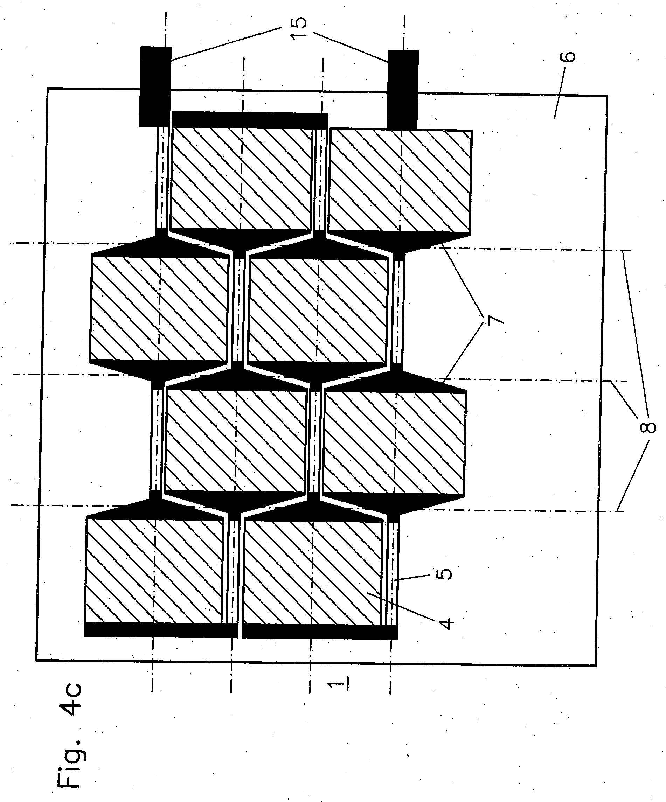

In **Fig. 4c** ist eine weitere Ausführungsform der Matrix 1 dargestellt, die vorteilhaft ist, wenn die Materialien der Thermoschenkel ähnlich wie in **Fig. 4a** und **Fig. 4b** unterschiedliche elektrische Leitfähigkeiten aufweisen und zusätzlich der effektive Weg des Stromes im Kontaktbereich **7** minimiert werden soll.

Im Falle von unterschiedlich hohen Feldern kann der Kontaktbereich 7 zwischen den n- und p-Leitern **4,5** angepasst werden. In **Fig. 4a** entspricht die Höhe des Kontaktbereichs **7** der Höhe des Materials'mit der geringeren elektrischen Leitfähigkeit. Da der Kontaktbereich **7** gleichzeitig der Umkehrpunkt beim ziehharmonikaartigen Falten ist, sollte diese Knickstelle über einen möglichst große Materialfläche verlaufen, damit die durch die Faltung hervorgerufenen mechanische Belastung, welche ggf. zu Haarrissen in dem Kontaktbereich **7** führen kann, kompensiert werden kann. In **Fig. 4b** ist dieser Kontaktbereich **7** vom besseren Leiter zum stärkeren Leiter dreieckförmig verjüngt. Aus dieser Geometrie ergibt sich ein größerer Kontaktbereich **7** an der Knickstelle verglichen mit der Ausführung in **Fig. 4a****.**

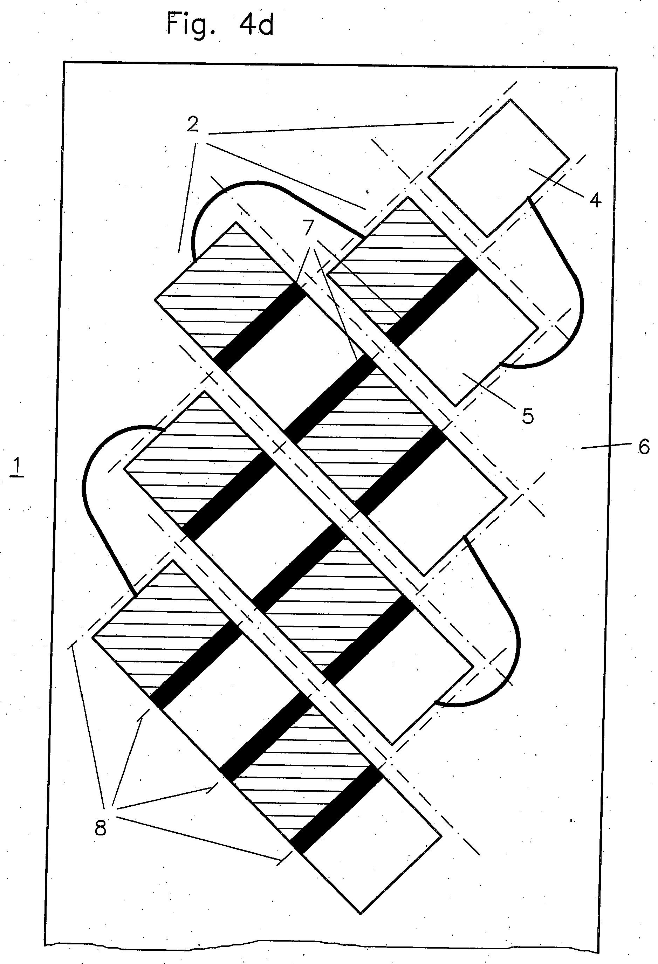

Eine weitere Ausführungsform der Matrix **1** umfasst eine abgewinkelte Zeilenführung der n- und p-Leiter **4,5** wie sie in **Fig. 4d** abgebildet ist. Hier ist zu erkennen, dass die Matrix **1** in einem Winkel zur Fertigungsrichtung gewickelt wird, damit die Wicklung parallel der Zeilen **2** ist und die Faltlinien **8** übereinander liegen. Der aus dieser Wicklung entstehende Streifen **10** verlängert sich mit jeder Lage in Zeilenrichtung. Diese Ausführung ist vorteilhaft beim Endlosverfahren, da der Beschichtungsprozess nicht unterbrochen werden braucht, wenn ein Thermoelektrisches System **11** von gewünschter Größe erzielt wurde. Es ist möglich den erhaltenen Streifen **10** bei entsprechender Länge zu kappen, um ihn der Faltung zuzuführen.

### Beispiel 1: Herstellung eines erfindungsgemäßen TEG

Eine Matrix **1** umfassend elf Zeilen **2** mit insgesamt 93 Thermöpaaren **3** wurde auf einer 12 µm dicken Substratfolie aus Polyester als flexible isolierende Schicht **6** bedruckt. Versuchsweise wurden als die ein Thermopaar **4** bildenden thermoelektrisch aktiven Materialien metallisches Silber als n-Leiter **5** und Polysulfonsäure-dotiertes Poly-3,4-ethylendioxythiophen (PEDOT:PSS) als p-Leiter **4** verwendet. Zunächst wurde die Folie **6** auf ein DIN A 4-Reinraumpapier auf den Vakuumtisch einer Siebdruckmaschine gelegt. Nach Ansaugen und Glattstreichen der Folie **6** wird zuerst mit dem 165-27er Sieb eine Silberpaste aufgedruckt. Nach dem Druck wurde die Folie bei 120°C im Ofen ca. 10 Minuten getrocknet. Danach wurde nacheinander dreimal PEDOT:PSS Tinte mit einem 10-260er Sieb gedruckt und ebenfalls jeweils ca. 10 Minuten im Ofen getrocknet. Die Thermopaarelemente waren kontaktiert durch eine Zwischenschicht **7**, die im vorliegenden Fall ein Überlappbereich der beiden thermoelektrisch aktiven Materialien waren.

Nach dem Drucken wurden seitlich oben und unten die Anfänge der Thermopaar-Reihenschaltung mit Silberleitlack als Kontaktfläche **15** kontaktiert. Dann wurde die Folie **6** so zugeschnitten, dass oberhalb der ersten.Zeile **2** etwa so viel unbedruckte Folie **6** verblieb, dass sie die erste Zeile **2** überlappen konnte. Anschließend wurde die Matrix **1** Zeile um Zeile aufgewickelt, wobei zuerst die unbedruckte Folie **6** auf die benachbarte Zeile **2** aufgelegt wurde. Nach dem Umschlagen des letzten Folienüberstands, wurde dieser Umschlag mittels eines Bügeleisens auf den entstandenen Streifen **10** gesiegelt. Damit wurde ein selbstständiges Entwickeln verhindert. Der Streifen **10** wurde nun ziehharmonikaartig zu einem Stapel aufgefaltet wie in **Fig. 3** dargestellt. Die Faltstellen jeder Zeile **2** befinden sich übereinander an den Kontaktbereichen **7**. Anschließend wurde der Stapel mit einem Streifen Kaptonband zu einem Block komprimiert.

### Beispiel 2: Spannungsmessung

Der in Beispiel 1 erhaltene thermoelektrische System **11** wurde als thermoelektrischer Generator (TEG) **14** eingesetzt und die entstanden elektrische Spannung aufgezeichnet. Für diese Messungen wurde ein thermoelektrisches System **11** in eine Messvorrichtung, die ein thermisches Gefälle erzeugen kann, wie in **Fig. 3** schematisch dargestellt, eingespannt. Für die Messung wurde eine Seite des TEG Bei 20°C gehalten, während die andere Seite schrittweise bis auf 145°C erwärmt wurde. An den Kontaktstellen **15 des** Stapels wurde gleichzeitig die entstandene Spannung gemessen. In Fig. 6 ist die Spannungsentwicklung sowie die Leistung als Funktion des Temperaturunterschieds ΔT zwischen den beiden Thermoblöcken **12,13** aufgetragen. Die gemessene Ausgangsspannung ΔU der TEG ändert sich proportional zur angelegten Temperaturdifferenz ΔT. Ebenfalls aufgezeichnet ist dort die Änderung der Leistung, welche wegen der quadratischen Abhängigkeit von der Spannung quadratisch mit steigender Temperaturdifferenz ΔT ansteigt. Diese Messwerte belegen, dass mittels des erfindungsgemäßen thermoelektrischen Systems **11** wirkungsvoll elektrischer Strom produziert werden kann.

### Bezugszeichenliste

- 1: Matrix
- 2: Zeilen
- 3: Thermopaar
- 4: n-Leiter
- 5: p-Leiter
- 6: elektrisch isolierende Schicht
- 7: Kontaktbereich
- 8: Faltlinien
- 9: Spalten
- 10: Streifen
- 11: thermoelektrisches System
- 12: Thermoblock
- 13: Thermoblock
- 14: thermoelektrischer Generator
- 15: Kontaktfläche
- 16: Doppelzeile
- ΔT: Temperaturdifferenz
- ΔU: Spannungsdifferenz

## Patentansprüche

1. Thermoelektrisches System (11) umfassend eine Vielzahl von Thermopaaren (3) aus jeweils zwei Thermoschenkeln unterschiedlicher thermoelektrisch aktiver Materialien (4,5), welche elektrisch in Serie und thermisch parallel geschaltet sind und welche in Form einer Matrix (1) aus n Zeilen (2) mit einer beliebigen Anzahl von Thermoschenkeln in Spalten (9) gleicher Breite auf eine flexible und elektrisch isolierende Schicht (6) derart aufgebracht sind, dass die Kontaktbereiche (7) benachbarter Thermoschenkel (4,5) jeweils auf geraden Faltlinien (8) übereinander in Spaltenrichtung befindlich sind, und wobei die Matrix (1) parallel der Zeilen (2) übereinander zu einem flachen Streifen (10) gewickelt ist und dann entlang der Faltlinien (8) ziehharmonikaartig mit Erhebungen und Vertiefungen gleichen Abstands zueinander gefaltet ist.

2. Thermoelektrisches System (11) nach Anspruch 1, wobei die Kontaktbereiche (7) zwischen den beiden Thermoschenkeln (4,5) mittels einer kontaktverbessernden Zwischenschicht versehen sind.

3. Thermoelektrisches System nach Anspruch 1 oder 2, wobei der gefaltete Streifen (10) auf Block verpresst ist.

4. Thermoelektrisches System (11) nach einem der Ansprüche 1 bis 3, wobei die unterschiedlichen, das Thermopaar (3) bildendenden Thermoschenkel (4,5) aus thermoelektrisch aktiven Materialien entsprechend ihrer elektrischen Leitfähigkeit in unterschiedlicher Fläche auf die flexible und elektrisch isolierende Schicht (6) aufgebracht sind.

5. Thermoelektrisches System (11) nach einem der Ansprüche 1 bis 4, wobei die flexible und elektrisch isolierende Schicht (6) eine Kunststofffolie, ein Gewebe oder ein Lack ist.

6. Thermoelektrisches System nach einem der Ansprüche 1 bis 5, wobei die flexible und elektrisch isolierende Schicht (6) auf der Rückseite eine aktivierbare Klebeschicht umfasst.

7. Verfahren zur Herstellung eines thermoelektrischen Systems (1) gemäß der Ansprüche 1 bis 6, umfassend folgende Schritte:
(i) Herstellen einer Matrix (1) aus Thermopaare (3) bildenden Thermoschenkeln (4,5) durch Aufbringen von dünnen Schichten thermoelektrisch aktiver Materialien und gegebenenfalls eine diese elektrisch verbindende Zwischenschicht auf eine flexible und elektrisch isolierende Schicht (6), sodass n Zeilen (2) (mit n ≥ 2) mit einer beliebigen Anzahl an Thermoschenkeln (4,5) entstehen, wobei die Kontaktbereiche (7) der Thermoschenkel (4,5) jeweils auf Faltlinien (8) in Spaltenrichtung befindlich sind, und wobei die jeweiligen Zeilenenden einen Kontaktbereich (7) mit der benachbarten Zeile (2) ausbilden, damit ein serieller Stromfluss S-förmig über die gesamte Matrix (1) gewährleistet ist,
(ii) Aufwickeln der Matrix (1) parallel der Zeilen (2), sodass die Zeilen (2) elektrisch gegeneinander isoliert übereinander liegen, wobei ein mehrlagiger Streifen (10) mit 2 bis 250 Lagen entsteht, und
(iii) ziehharmonikaartiges Falten des mehrlagigen Streifens (10) entlang der Faltlinien (8) in Spaltenrichtung mit Erhebungen und Vertiefungen gleichen Abstands zueinander.

8. Verfahren nach Anspruch 7, wobei die dünne, flexible und elektrisch isolierende Schicht (6) als Lack auf eine glatte Oberfläche aufgesprüht werden, bevor die thermoelektrisch aktiven Materialien (4,5) sowie die Zwischenschichten aufgebracht werden.

9. Verfahren nach Anspruch 7, wobei die dünne, flexible und elektrisch isolierende Schicht (6) mit einer Klebeschicht auf der Rückseite versehen wird.

10. Verfahren nach einem der Ansprüche 7 bis 9, wobei das gewickelte und gefaltete thermoelektrische System (11) in einem Folgeschritt aneinander haftend auf Block verpresst wird.

11. Verfahren nach einem der Ansprüche 7 bis 10, wobei die thermoelektrisch aktiven Materialien (4,5) auf die elektrisch isolierende Schicht (6) aufgedruckt werden.

## Claims

1. Thermoelectric system (11), comprising a plurality of thermocouples (3), formed in each case of two thermocouple limbs made of different thermoelectrically-active materials (4, 5), which are connected electrically in series and thermally in parallel, and which are located in the form of a matrix (1) of n rows (2), with any desired number of thermocouple limbs in gaps (9) of the same width, onto a flexible and electrically insulating layer (6) in such a way that the contact regions (7) of adjacent thermocouple limbs (4,5) are located in each case on straight fold lines (8), above one another in the gap direction, and wherein the matrix (1) is wound parallel to the rows (2) above one another to form a flat strip (10), and is then folded along the fold lines (8) in concertina fashion with elevations and depressions of the same interval spacing to one another.

2. Thermoelectric system (11) according to claim 1, wherein the contact regions (7) are provided between the two thermocouple limbs (4, 5) by means of a contact-improving intermediate layer.

3. Thermoelectric system according to claim 1 or 2, wherein the folded strips (10) are pressed to form a block.

4. Thermoelectric system (11) according to any one of claims 1 to 3, wherein the different thermocouple limbs (4, 5) forming the thermocouple (3), made of different thermoelectrically-active materials, are applied, in accordance with their electrical conductivity in different surfaces, onto the flexible and electrically insulating layer (6).

5. Thermoelectric system (11) according to any one of claims 1 to 4, wherein the flexible and electrically insulating layer (6) is a plastic film, a fabric, or a lacquer.

6. Thermoelectric system according to any one of claims 1 to 5, wherein the flexible and electrically insulating layer (6) comprises on the rear side an activatable adhesive layer.

7. Method for producing a thermoelectric system (1) according to claims 1 to 6, comprising the following steps:
(i) Production of a matrix (1) of thermocouple limbs (4, 5) forming thermocouples (3), by the application of thin layers of thermoelectrically-active materials and, as appropriate, an intermediate layer connecting these layers electrically, onto a flexible and electrically insulating layer (6), such that n rows (2) (with n ≥ 2) with any desired number of thermocouple limbs (4, 5) are formed, wherein the contact regions (7) of the thermocouple limbs (4, 5) are located in each case on fold lines (8) in the gap direction, and wherein the respective row ends form a contact region (7) with the adjacent row (2), such that a serial current flow in S-shape is ensured over the entire matrix (1),
(ii) winding up of the matrix (1) parallel to the rows (2), such that the rows (2) lie above one another, electrically insulated from one another, wherein a multi-layer strip (10) with 2 to 250 layers is formed, and
(iii) concertina-type folding of the multi-layer strip (10) along the fold lines (8) in the gap direction, with elevations and depressions of equal distance spacing from one another.

8. Method according to claim 7, wherein the thin, flexible, and electrically insulating layer (6) is sprayed as a lacquer onto the smooth surface, before the thermoelectrically-active materials (4, 5) and the intermediate layers are applied.

9. Method according to claim 7, wherein the thin, flexible, and electrically insulating layer (6) is provided with an adhesive layer on the rear side.

10. Method according to one of claims 7 to 9, wherein the wound and folded thermoelectric system (11), in a following step, is pressed into a block, the elements adhering to one another.

11. Method according to one of claims 7 to 10, wherein the thermoelectrically-active materials (4, 5) are printed onto the electrically insulating layer (6).

## Revendications

1. Système thermoélectrique (11) comprenant plusieurs thermocouples (3) constitués chacun de deux thermo-branches en des matériaux thermo-électriquement actifs différents (4, 5) qui sont montés électriquement en série et thermiquement en parallèle et qui sont appliqués sous la forme d'une matrice (1) de n cellules (2) ayant un nombre quelconque de thermo-branches dans des colonnes (9) de même largeur, sur une couche (6) flexible et électriquement isolante de sorte que les zones de contact (7) de thermo-branches (4, 5) voisines soient respectivement situées sur des lignes de pliage rectilignes (8) les unes au-dessus des autres dans la direction des colonnes, et la matrice (1) étant enroulée sur elle-même parallèlement aux lignes (2) en une bande plate (10) puis, étant pliée en accordéon le long des lignes de pliage (8) avec des sommets et des creux situés à la même distance les uns des autres.

2. Système thermoélectrique (11) conforme à la revendication 1,
dans lequel les zones de contact (7) entre les deux thermo-branches (4, 5) sont équipées d'une couche intermédiaire améliorant le contact.

3. Système thermoélectrique conforme à la revendication 1 ou 2,
dans lequel la bande repliée (10) est comprimée en un bloc.

4. Système thermoélectrique (11) conforme à l'une des revendications 1 à 3,
dans lequel les thermo-branches (4, 5) en matériau thermo-électriquement actif formant le thermocouple (3) sont appliquées conforcément à leur conductibilité électrique dans des surfaces différentes sur la couche (6) flexible et électriquement isolante.

5. Système thermoélectrique (11) conforme à l'une des revendications 1 à 4,
dans lequel la couche (6) flexible et électriquement isolante est un film en matériau synthétique, un tissu ou un vernis.

6. Système thermoélectrique conforme à l'une des revendications 1 à 5, dans lequel la couche (6) flexible et électriquement isolante est équipée sur sa face arrière d'une couche d'adhésif pouvant être activée.

7. Procédé d'obtention d'un système thermoélectrique (1) conforme aux revendications 1 à 6,
comprenant les étapes suivantes consistant à :
(i) fabriquer une matrice (1) de thermo-branches (4, 5) formant des thermocouples (3) par application de couches minces de matériaux thermo-électriquement actifs et le cas échéant d'une couche intermédiaire reliant électriquement celles-ci sur une couche flexible et électriquement isolante (6) de façon à obtenir n cellules (2) (avec n ≥ 2) ayant un nombre quelconque de thermo-branches (4, 5), les zones de contact (7) des thermo-branches (4, 5) se trouvant respectivement sur des lignes de pliage (8) dans la direction des colonnes, et les extrémités respectives de cellules formant une zone de contact (7) avec la cellule voisine (2) de façon à garantir un flux de courant en série en forme de S sur la totalité de la matrice (1),
(ii) enrouler la matrice (1) parallèlement aux cellules (2) de sorte que les cellules (2) soient situées les unes sur les autres en étant électriquement isolées les unes par rapport aux autres, une bande (10) multicouches ayant 2 à 250 couches étant ainsi obtenue, et
(iii) plier en accordéon la bande multicouches (10) le long des lignes de pliage (8) dans la direction des colonnes avec des sommets et des creux ayant la même distance les uns par rapport aux autres.

8. Procédé conforme à la revendication 7,
selon lequel la couche mince flexible et électriquement isolante (6) est pulvérisée sous la forme d'un vernis sur une surface lisse avant l'application des matériaux thermo-électriquement actifs (4, 5) ainsi que des couches intermédiaires.

9. Procédé conforme à la revendication 7,
selon lequel la couche mince flexible et électriquement isolante (6) est équipée d'une couche d'adhésif sur sa face arrière.

10. Procédé conforme à l'une des revendications 7 à 9,
selon lequel le système thermoélectrique enroulé et replié (11) est compacté par adhésion en un bloc dans une étape ultérieure.

11. Procédé conforme à l'une des revendications 7 à 10,
selon lequel les matériaux thermoélectriquement actifs (4, 5) sont comprimés sur la couche électriquement isolante (6).
